# EUROPEAN PATENT APPLICATION

(11) **EP 2 267 197 A1**
(43) Date of publication of application: **29.12.2010**
(21) Application number: 09460026.9
(22) Date of filing: 25.06.2009
(51) Int. Cl.: C30B 29/40, C30B 33/02, C30B 9/00

(54) **Method of obtaining bulk mono-crystalline gallium-containing nitride, bulk mono-crystalline gallium-containing nitride, substrates manufactured thereof and devices manufactured on such substrates**

(71) Applicant: AMMONO Sp.z o.o., 00-377 Warszawa (PL)
(72) Inventor: Dwilinski, Robert Tomasz, 01-875 Warszawa (PL); Doradzinski, Roman Marek, 02-793 Warszawa (PL); Sierzputowski, Leszek Piotr, 00-377 Warszawa (PL); Garczynski, Jerzy, 05-092 Lomianki (PL); Rudzinski, Mariusz, 11-700 Mragowo (PL)
(74) Representative: Dohmen, Johannes Maria Gerardus

(57) **Abstract**

The invention is related to a method of obtaining bulk mono-crystalline gallium-containing nitride by crystallization on a seed from supercritical ammonia-containing solution, containing ions of Group I metals and ions of acceptor dopant. According to said method at process conditions the molar ratio of acceptor dopant ions to supercritical ammonia-containing solvent is at least 0.0001. The invention covers also bulk mono-crystalline gallium-containing nitride, obtainable by the inventive method. The invention further relates to substrates for epitaxy made of mono-crystalline gallium-containing nitride and devices manufactured on such substrates.

## Description

### Technical Field

The invention is related to a method of obtaining doped bulk mono-crystalline gallium-containing nitride and the thus obtained nitride. Said nitride is used especially in electronic industry to manufacture substrates as well as electronic and opto-electronic devices. The invention covers also substrates made of doped bulk mono-crystalline gallium-containing nitride and devices, especially electronic and opto-electronic devices, manufactured on such substrates.

### Background

Various methods of obtaining gallium-containing nitride, and especially - gallium nitride, are known in the art. In particular, epitaxial methods should be mentioned here, as for example MOCVD (Metal-Organic Chemical Vapor Deposition), HVPE (Hydride Vapor Phase Epitaxy) or MBE (Molecular Beam Epitaxy) method [see e.g. "Optical patterning of GaN films" M.K.Kelly, O.Ambacher, Appl. Phys. Lett. 69 (12) (1996) and "Fabrication of thin-film InGaN light-emitting diode membranes" W.S.Wrong, T. Sands, Appl. Phys. Lett. 75 (10) (1999)], methods of crystallization from melt and sublimation methods [e.g. "GaN growth by sublimation sandwich method" M. Kaminski, A. Waszkiewicz, S. Podsiado et al. Physica Status Solidi vol. 2, no. 3, p. 1065-1068], HNP (High Nitrogen Pressure) method [e.g. "Prospects for high-pressure crystal growth of III-V nitrides" S.Porowski et al., Inst. Phys. Conf. Series, 137, 369 (1998)] or- last but not least - methods of growth from a melted gallium-alkali metal alloy under the atmosphere of nitrogen (so-called FLUX methods) [e.g. Youting Song et al., Journal of Crystal growth 247 (2003) 275-278]. However, none of these methods is fully satisfactory, because they do not allow for obtaining crystals of desired size, quality and/or properties, or their efficiency and industrial applicability is limited.

The published patent application WO02101120 discloses a method of obtaining bulk mono-crystalline gallium-containing nitride by selective crystallization from supercritical ammonia-containing solution on a seed. This method enables obtaining bulk nitride single crystals of large dimensions and of very high crystalline quality. Publications WO2004053206, WO2006057463 and Polish published patent application no. P-371405 disclose a method for controlled intentional doping of such crystals. Finally, Polish published patent application no. P-372746 and publication WO2005122232 describe how to obtain a material having desired electrical properties, according to the intended application of the material, as the result of doping. According to the disclosure of P-372746 and publication WO2005122232, it is possible to obtain substrates of bulk mono-crystalline gallium-containing nitride, doped with acceptors at the level of 500ppm and highly resistive (i.e. having resistivity of about 10⁶Ω·cm).

From the technological point of view, a very important feature of semiconductor materials, used among others to manufacture substrates for epitaxy, is the thermal stability of such materials. This is because thermal stability enables:
a) obtaining high-quality epitaxial layers, and
b) using the substrate again in another epitaxial process.

### Summary

It is thus the object of the present invention to provide a method of obtaining bulk mono-crystalline gallium-containing nitride which is more stable at high temperature, especially at the conditions of an epitaxial process, has uniform volume distribution of dopants, and in the case of compensated (semi-insulating) material - has even higher resistivity. It is a further object of the invention to provide such material, substrates of such material and electronic structures obtained on such substrates or using such material.

The authors of the present invention unexpectedly discovered that by remarkably increasing the amount of acceptor dopant in the manufacturing process of bulk mono-crystalline gallium-containing nitride, at least by one order of magnitude comparing to concentrations known from P-372746 and WO2005122232, resulted in a higher thermal stability of the obtained material at the conditions of epitaxial process (temperature up to 1200°C depending on the method (MBE, HVPE, MOCVD); duration - from several minutes to several dozen hours). It has turned out that the inventive material is characterized by a higher thermal stability than the material disclosed in published Polish patent applications no. P-371405 and P-372746, as well as in publications WO2005122232 and WO2006057463, which in particular means that substrates made of the inventive material can be used more times in an epitaxial process. This effect is surprising, because the overall contents of dopants in the inventive material is within a known range (about 10¹⁷/cm³ to 10²¹/cm³), while the thermal stability of the material is remarkably higher. It is speculated that the effect may be due to the location of dopant atoms in the crystalline lattice of the material, which may be different than that for materials known in art. In connection with the thermal stability tests, it has been further discovered, that higher doping combined with appropriate thermal treatment enables shaping electrical properties of the material, in particular conductivity type, carrier concentration and resistivity. In addition, in each case the thus obtained material is thermally stable. Moreover, uniform volume distribution of dopants in the material has been proven.

The method of obtaining bulk mono-crystalline gallium-containing nitride by seeded crystallization from supercritical ammonia-containing solution, containing ions of Group I metals and ions of acceptor dopant, according to the invention, is **characterized in that** at process conditions the molar ratio of acceptor dopant ions to supercritical ammonia-containing solvent is at least 0.0001, preferably at least 0.0005, more preferably at least 0.0010.

Preferably, in the method according to the invention, the acceptor dopant is at least one element selected from the group consisting of Mg, Zn, Mn.

In a preferred embodiment of the present invention, after the crystallization step the nitride is annealed in the atmosphere of a nitrogen-containing gas, preferably comprising molecular nitrogen N₂, ammonia NH₃ or a mixture thereof.

The temperature of annealing is between 800°C and 1200°C, preferably between 950°C and 1150°C, while the duration of annealing is between 0.5h and 16h, preferably between 2h and 6h.

The invention covers also a bulk mono-crystalline gallium-containing nitride, obtainable by the inventive method. Such a bulk mono-crystalline gallium-containing nitride is **characterized in that** its crystalline quality essentially does not change when it is used in an epitaxial growth process at temperatures up to 1200°C. It means that during and after an epitaxial process at high temperatures the characteristics of the inventive material related to the arrangement of atoms in the crystalline lattice, as well as continuity of the lattice, is preserved. No defects such as cracks, voids, precipitates of other phases or amorphous material were observed after the epitaxial process. As the result, measurable parameters of the inventive material, such as full width at half maximum of the X-ray rocking curve (FWHM) or radius of curvature of the crystalline lattice, remain essentially unchanged. This feature of the inventive material results in a practical advantage, that substrates made of the inventive material can be used more times in an epitaxial process.

It has been found that the inventive bulk mono-crystalline gallium-containing nitride is doped with acceptor dopant at the amount of 10¹⁷/cm³ to 10²¹/cm³. Preferably, the acceptor dopant is at least one element selected from a group consisting of Mg, Zn, Mn.

In a preferred embodiment of the present invention, the nitride according to the invention constitutes a p-type material, which resistivity is preferably not exceeding 10³Ω·cm, more preferably not exceeding 10²Ω·cm, most preferably not exceeding 10¹Ω·cm.

In another preferred embodiment of the present invention, the nitride according to the invention constitutes a semi-insulating material, which resistivity is preferably at least 10⁵Ω·cm, more preferably at least 10⁷Ω·cm, and most preferably at least 10¹⁰Ω·cm.

The inventive bulk mono-crystalline gallium-containing nitride may reveal blue luminescence.

The invention covers also a substrate of bulk mono-crystalline gallium-containing nitride. Such substrate, due to its improved thermal stability, can be repeatedly used in epitaxial processes.

As far as the geometry of the inventive substrate is concerned, the substrates can be prepared according to requirements of their intended use. In particular, they may be wafers of rectangular or square shape, preferably having dimensions exceeding 10mm x 10mm, more preferably exceeding 15mm x 15mm. Alternatively they may be round wafers, preferably having the diameter exceeding 25mm (1 inch), more preferably exceeding 50mm (2 inch).

The substrates may be polished. In particular, their epitaxial surface may be polished up to and including the so-called epi-ready stage.

In a preferred case, the epitaxial surface of the inventive substrate essentially coincides with a polar crystallographic plane of the crystalline lattice of gallium-containing nitride. In particular, it may be the C⁺ plane, having the Miller indices (0001) - the so-called Ga face, or else it may be the C- plane, having the Miller indices (0001̅) - the so-called N face.

In the case of essentially polar substrates the surface dislocation density, as measured by the Etch Pit Density (EPD) method on the epi-ready surface, is not higher than 1.0x10⁵/cm², preferably not higher than 1.0x10⁴/cm², and most preferably not higher than 1.0x10³/cm².

For other applications, the epitaxial surface of the inventive substrate is semi-polar, which means that it is tilted off the polar crystallographic plane. In particular, it may essentially coincide with the crystallographic planes having the following Miller indices: (112̅2), (101̅1), (101̅2). In another preferred embodiment, the epitaxial surface of the inventive substrate is essentially non-polar. In particular, it may essentially coincide with the A plane, having the Miller indices (112̅0), or with the M plane, having the Miller indices (11̅00).

In the case of essentially non-polar substrates the surface dislocation density, as measured by the Etch Pit Density (EPD) method on the epi-ready surface, is not higher than 1.0x10⁴/cm², preferably not higher than 1.0x10³/cm², and most preferably not higher than 1.0x10²/cm².

In any case, because of the demands of epitaxial process, the substrate surface may be intentionally inclined from a given crystallographic plane (e.g. C plane, M plane. or A-plane) by a certain angle (called an off-angle), which typically does not exceed 5°. For this reason, we use the terms "essentially polar" or "essentially non-polar" to describe substrate surfaces which are slightly misoriented from a polar or non-polar crystallographic planes, respectively.

The substrate according to the invention may be p-type. Preferably it has the resistivity not exceeding 10³Ω·cm, more preferably not exceeding 10²Ω·cm, most preferably not exceeding 10¹Ω·cm.

Alternatively, the substrate according to the invention may be semi-insulating. Preferably it has the resistivity of at least 10⁵Ω·cm, more preferably at least 10⁷Ω·-cm and most preferably at least 10¹⁰Ω·cm.

The invention covers also devices obtained on the inventive substrate of bulk mono-crystalline gallium-containing nitride. A p-type substrate is the preferred substrate for devices such as a laser, a LED diode, a UV detector, a solar cell, a polarized-light emitter or a polarized-light detector. Lasers, LED diodes, and UV detectors may be realized on polar, semi-polar or non-polar substrates. On the other hand, for the polarized-light emitter and detector, non-polar substrates are preferred.

A semi-insulating substrate is the preferred substrate for devices such as a high electron mobility transistor, HEMT, an integrated circuit, IC, a solar cell, a UV detector, or a photoresistor. Those devices may be realized on polar, semi-polar or non-polar substrates.

In one preferred embodiment, a high electron mobility transistor according to the invention includes a substrate of the inventive bulk mono-crystalline gallium-containing nitride, a buffer layer of GaN, deposited directly on the substrate and a layer of AlₓGa₁₋ₓN, 0<x≤1, deposited directly on the buffer layer of GaN. Said buffer layer of GaN is highly resistive. High electrical resistivity of this layer may be a result of lack of intentional doping or else a result of intentional doping with Fe, C, Zn or Mn. In case of intentional doping with Fe, the doped material of the buffer layer is situated closer to the substrate and preferably has the thickness from 10nm to 600nm, while the rest of the buffer layer, situated farther from the substrate, may be undoped and preferably has the thickness between 0.8µm and 2.4µm. Even more preferably, thicker layer of doped material is associated with thicker layer of undoped material. In particular, when the doped material has the thickness of 10nm, the undoped material should have the thickness of 0.8µm, when the doped material has the thickness of 600nm, the undoped material should have the thickness of 2.4µm, while intermediate thickness of the doped material (between 10nm and 600nm) should be associated with intermediate thickness of the undoped material (between 0.8µm and 2.4µm, respectively). In case of intentional doping with C, Zn or Mn, similar dependency should be expected.

In another preferred embodiment, a high electron mobility transistor according to the invention includes a substrate of the inventive bulk mono-crystalline gallium-containing nitride, a buffer layer of GaN, deposited directly on the substrate and a layer of AlₓGa₁₋ₓN, 0<x≤1, deposited directly on the buffer layer of GaN. Said buffer layer of GaN has the thickness between 0.5nm and 5nm, which means that it consists of one or several atomic mono-layers. So thin layers do not have to be highly resistive. Preferably, they may be doped with Si. Moreover, such a thin layer secures flatness of the substrate.

In another preferred embodiment, a high electron mobility transistor according to the invention includes a substrate of the inventive bulk mono-crystalline gallium-containing nitride, a buffer layer of undoped GaN, deposited directly on the substrate and a layer of AlₓGa₁₋ₓN, 0<x≤1, deposited directly on the buffer layer of GaN. Said buffer layer of GaN has the thickness between 5nm and 50nm. Presence of the buffer layer has both smoothing and flattening effects on the epitaxially grown surface.

In yet another preferred embodiment, a high electron mobility transistor according to the invention includes a substrate of the inventive bulk mono-crystalline gallium-containing nitride, a buffer layer of GaN, deposited directly on the substrate, a layer of AIN, deposited directly on the buffer layer of GaN and a layer of AlₓGa₁₋ₓN, 0<x≤1, deposited directly on the buffer layer of AIN. Said buffer layer of GaN may be highly resistive, e.g. due to the aforementioned reasons. Alternatively, it may be thin - having the thickness between 0.5nm and 5nm, which means that it consists of one or several atomic mono-layers. So thin layers do not have to be highly resistive. Preferably, they may be doped with Si. Moreover, such a thin layer secures flatness of the substrate.

In another preferred embodiment, a high electron mobility transistor according to the invention includes a substrate of the inventive bulk mono-crystalline gallium-containing nitride and a layer of AlₓGa₁₋ₓN, 0<x≤1, deposited directly on the substrate.

In yet another preferred embodiment, a high electron mobility transistor according to the invention includes the substrate, an epitaxial layer of AlₓGa₁₋ₓN, 0<x≤1, doped with Si, deposited on the N-side of the substrate, a layer of undoped AlₓGa₁₋ₓN, 0<x≤1, deposited on the layer of AlₓGa₁₋ₓN, 0<x≤1, doped with Si, and a layer of undoped GaN, deposited on the layer of undoped AlₓGa₁₋ₓN, 0<x≤1.

The material obtained by the inventive method and substrates made of this material are characterized by stability at the condition of high temperature, as present in an epitaxial process, by uniform volume distribution of dopants, and in the case of compensated (semi-insulating) material - by resistivity above 10⁵Ω·cm, preferably 10⁷Ω·cm, more preferably above 10¹⁰Ω·cm. As far as the p-type material is concerned, the inventive method enables obtaining single crystals, which - in a preferred case - are characterized by the hole concentration of 10¹¹ - 10¹⁹/cm3, mobility from a dozen to several hundred cm²/(V·s) (the values of concentration and mobility measured at room temperature) and resistivity not exceeding 10³Ω·cm, preferably not exceeding 10²Ω·cm, most preferably not exceeding 10¹Ω·cm. Higher thermal stability allows for multiple use of substrates for epitaxy made of the inventive material. Further advantages include outstanding crystalline quality of the material, the substrate and epitaxial layers deposited thereon. For the material obtained by the inventive method it has been stated that its FWHM of X-ray rocking curve from (0002) plane is preferably lower than 20arcsec (for Cu K α1 line), its radius of curvature of the crystalline lattice is preferably higher than 90m, and its surface dislocation density, measured by the Etch Pit Density (EPD) method is preferably not higher than 1x10²/cm². For epitaxial layers deposited on the inventive substrate a model ("book") photoluminescence spectrum has been observed, in a uniquely reproducible manner throughout the whole surface of the substrate. The aforementioned advantages result in exceptionally high structural quality and exceptionally favorable performance of devices obtained on the inventive substrates or comprising the inventive bulk mono-crystalline gallium-containing nitride.

### Brief Description of the Drawings

Several embodiments of the present invention are presented in a more detailed way on the attached drawing, in which:
Fig. 1 presents a diagram of temperature change in time in Example 1;
Fig. 2 shows the contents of magnesium (Mg) in the substrate obtained in Example 2, measured by the SIMS (Secondary Ion Mass Spectroscopy) method;
Fig. 3 presents photoluminescence spectrum of epitaxial layer deposited on the substrate obtained in Example 2;
Fig. 4 presents a HEMT (High Electron Mobility Transistor) structure realized on the substrate obtained in Example 2
Fig. 5 presents another embodiment of a HEMT (High Electron Mobility Transistor) structure;
Fig. 6 presents yet another embodiment of a HEMT (High Electron Mobility Transistor) structure and
Fig. 7 presents a structure of a UV-detector, realized on the substrate obtained in Example 2.

### Detailed Description

Any technical terms used throughout the specification and the claims related to the present invention should be construed according to the definitions given below (in alphabetical order):
**Bulk mono-crystalline gallium-containing nitride** is bulk mono-crystalline gallium-containing nitride obtained by the method according to the present invention, as well as a layer of such nitride.
**Crystallographic directions *c, a*** or ***m*** refer to *c, a* or *m* directions of hexagonal lattice, having the following Miller indices: *c* - [0001], *a* - [112̅0], *m* - [11̅00].
**Crystallographic planes *C, A*** or ***M*** refer to *C*-, *A*- or *M*-plane surfaces of hexagonal lattice, having the following Miller indices: *C* - (0001), *A* - (112̅0), *M* - (11̅00). The surfaces are perpendicular to the corresponding crystallographic directions (*c, a* and *m*).
**Gallium-containing nitride** is a chemical compound containing in its structure at least one atom of gallium and one atom of nitrogen. It includes, but is not restricted to, a binary compound - GaN, a ternary compound - AIGaN, InGaN or a quaternary compound AllnGaN, preferably containing a substantial portion of gallium, anyhow at the level higher than dopant content. The composition of other elements with respect to gallium in this compound may be modified in its structure insofar as it does not collide with the ammonobasic nature of the crystallization technique.
**Group XIII element-containing nitride** means a nitride of Group XIII element(s) (IUPAC, 1989), i.e. aluminum, gallium and indium either alone or in any combination. Gallium-containing nitride is the most preferred such nitride.
**Group XIII element-terminated side, Ga-terminated side, N-terminated side:** In the crystals having the wurtzite structure one can distinguish a crystalline direction (crystalline axis) denoted as *c*, parallel to the C₆ symmetry axis of the crystal. In the crystals of Group XIII element nitrides, having the wurtzite structure, the crystalline planes perpendicular to the *c* axis (*C*-planes) are not equivalent. Such crystalline planes are said to be **polar.** It is a habit to call them Group XIII element-terminated side and nitrogen-terminated side or the surface having Group XIII element polarity or nitrogen polarity, respectively. In particular, in the case of monocrystalline gallium nitride one can distinguish gallium-terminated side (Ga-side) and nitrogen-terminated side (N-side). These sides have different chemical and physical properties (eg. susceptibility to etching or thermal durability). In the methods of epitaxy from the gaseous phase the layers are deposited on the Group XIII element-terminated side. Crystalline planes parallel to the *c* axis are called **non-polar** planes. Examples of non-polar planes include *A* and *M* crystallographic planes. Crystalline planes tilted off the polar crystallographic planes are called **semi-polar.** Examples of semi-polar planes include the crystallographic planes having the following Miller indices: (112̅2), (101̅1), (101̅2).
**HVPE (Hydride Vapor Phase Epitaxy)** method refers to a method of deposition of epitaxial layers from gaseous phase, in which (in the case of nitrides) halides of metals and ammonia are used as substrates.
**MBE (Molecular Beam Epitaxy)** method refers to a method of obtaining epitaxial layers of atomic thickness by depositing molecules from a so-called "molecular beam" on a substrate.
**Mineralizer** is a substance introducing into the supercritical ammonia-containing solvent one or more Group I element (alkali metal) ions, supporting dissolution of feedstock.
**MOCVD (Metal-Organic Chemical Vapor Deposition)** method refers to a method of deposition of epitaxial layers from gaseous phase, in which (in the case of gallium nitride) ammonia and metallo-organic compounds of gallium are used as substrates.
**Substrate** means a wafer containing bulk mono-crystalline gallium-containing nitride, on which electronic devices may be obtained by MOCVD method or by other methods of epitaxial growth, such as MBE or HVPE, wherein its thickness is preferably at least 200µm, more preferably at least 500µm.
**Supercritical ammonia-containing solution** is a solution obtained as the result of dissolution of gallium-containing feedstock in the supercritical ammonia-containing solvent.
**Supercritical ammonia-containing solvent** is a supercritical solvent consisting at least of ammonia, which contains one or more types of Group I elements (alkali metals), supporting dissolution of gallium-containing nitride. Supercritical ammonia-containing solvent may also contain derivatives of ammonia and/or mixtures thereof, in particular - hydrazine.
**Temperature and pressure of the reaction:** In the practical example presented in the present specification temperature measurements inside the autoclave have been performed when the autoclave was empty, i.e. without the supercritical ammonia-containing solution. Thus, the temperature values cited in the examples are not the actual temperature values of the process carried out in the supercritical state. Pressure was measured directly or calculated on the basis of physical and chemical data for ammonia-containing solvent at selected process temperature and the volume of the autoclave.

Substrates of bulk mono-crystalline gallium-containing nitride are manufactured from doped bulk nitride single crystals, obtained by crystallization from supercritical ammonia-containing solution. This method was disclosed in publication WO02101120, and its abbreviated description is given below.

In this method, the process is carried out in a tightly closed pressurized container (autoclave), wherein in the crystallization stage the system contains gallium-containing feedstock, preferably crystalline gallium nitride, Group I elements and/or their mixtures, and/or their compounds, particularly those containing nitrogen and/or hydrogen, possibly with the addition of Group II elements and/or their compounds, which constitute the mineralizer. The mineralizer together with ammonia acts as the ammonia-containing solvent. Crystallization of the desired gallium-containing nitride is carried out from supercritical ammonia-containing solution on the surface of the seed at the crystallization temperature higher and/or crystallization pressure lower than the temperature and pressure of dissolution of feedstock. Two temperature zones are created and feedstock is placed in the dissolution zone while at least one seed is placed in the crystallization zone. The dissolution zone is located above the crystallization zone and transport of mass occurs between the dissolution zone and the crystallization zone. It is most preferred to use convective transport, which is carried out by maintaining the lower zone of the autoclave (i.e. the crystallization zone) at higher temperature than the upper zone of the autoclave (i.e. the crystallization zone). Under such conditions the feedstock is dissolved in the dissolution zone, while in the crystallization zone the state of supersaturation of supercritical ammonia-containing solution with respect to GaN is achieved, and selective crystallization of GaN on the seed is carried out.

The process can be conducted for example, in the device disclosed in the publication WO02101120. It is possible to use autoclaves that differ in terms of construction details as a result of, among others, the scale of the device.

As the seed, a single crystal of gallium-containing nitride obtained by any method is used. The proper dimensions and shape of seeds for producing bulk mono-crystalline gallium-containing nitride can be achieved by methods disclosed in published Polish patent application no. P-368483 and P-368781.

Bulk mono-crystalline gallium-containing nitride obtained by the above-described method can be doped with donor and/or acceptor and/or magnetic dopants, at concentrations from 10¹⁷/cm³ to 10²¹/cm³. Doping results in that the obtained gallium-containing nitride constitutes n-type, p-type or compensated (semi-insulating) material. The doping process is carried out according to the disclosure of published Polish patent applications no. P-371405 and P-372746, appropriately introducing dopants into the environment of single crystal growth. In the case of Group XIII element(s) nitrides, in particular - gallium nitride - examples of acceptor dopants include magnesium and zinc, donor dopants - silicon and magnetic dopants - manganese. The concentrations of dopants disclosed in the publications of Polish patent applications no. P-371405 and P-372746 are not significant, i.e. the molar ratio of dopant to ammonia are not higher than 5x10⁻⁵.

By this method single crystals of exceptionally high quality are obtained.

By remarkably increasing the amount of acceptor dopant in the process of manufacturing bulk mono-crystalline gallium-containing nitride (by at least one order of magnitude comparing to concentrations known from Polish patent applications no. P-371405 i P-372746), it is possible to obtain a material, which is more thermally stable at the conditions of epitaxial process (temperatures up to 1200°C depending on the method (MBE, HVPE, MOCVD); duration - from several minutes to several dozen hours).

The thus obtained material can be, in turns, annealed. For that purpose annealing in the atmosphere of a nitrogen-containing gas, such as molecular nitrogen N₂, ammonia or a mixture thereof, is applied. The temperature of the annealing process is from 800°C to 1200°C, while the duration is from 0.5h to 16h. Very good results were obtained for annealing in a tubular furnace at the temperatures of 1000°C or 1100°C, under nitrogen (N₂) flow, for 0.5h or 4h. Annealing allows for additional shaping of electrical properties of the material, in particular the type of conductivity, carrier concentration and resistivity. In each case the material is thermally stable. Moreover, uniform volume distribution of dopants in the material is observed.

Substrates are produced by cutting the inventive gallium-containing nitride single crystals (e.g. with a wire saw) into wafers with the desired dimensions and orientation with respect to the nitride crystalline lattice, followed by a typical processing method, consisting of - among others - mechanical polishing and chemical-mechanical polishing (CMP) of the wafers. On these substrates, in turns, electronic devices (structures), such as HEMT transistors, photoresistors, integrated circuits, laser diodes, LED diodes, UV detectors, solar cells, and also polarized-light detectors and emitters are manufactured. Such structures may be deposited for example by epitaxial methods known in art, such as HVPE, MBE or MOCVD, wherein due to thermal stability of the inventive substrates, they are suitable for multiple use in an epitaxial process. Some of devices are presented in the examples. In particular, for HEMT transistors, obtained on semi-insulating inventive substrates, it is possible to obtain a two-dimensional free electron gas (2DEG) having the mobility of µ=2200cm²/(V·s) and at the same time carrier concentration of nₛ=1x10¹³/cm².

Preferred embodiments of the invention are described in details below. The examples serve only as an illustration and do not limit the scope of the present invention.

### Example 1 - obtaining of doped bulk gallium-containing nitride (Mg:NH₃=0.0001).

In a high-pressure 1375cm³ autoclave, in the dissolution zone the feedstock in the form of 159g (ca. 2.28mol) of 6N metallic gallium was placed with the addition of 0.06g of magnesium as acceptor dopant. Next, 53g (ca. 2.31 mol) of 4N metallic sodium was introduced into the autoclave.

Sixteen wafers of mono-crystalline gallium nitride wafers, obtained by crystallization from supercritical ammonia-containing solution, having a pair of surfaces oriented perpendicular to the *c* axis of the mono-crystal, with the diameter of approx. 25mm (1 inch) and thickness of ca. 500µm each were used as seeds. The seeds were placed in the crystallization zone, at the bottom of the autoclave.

Next, the autoclave was filled with 467g (ca. 27.4mol) of ammonia (5N), closed and placed in the set of furnaces.

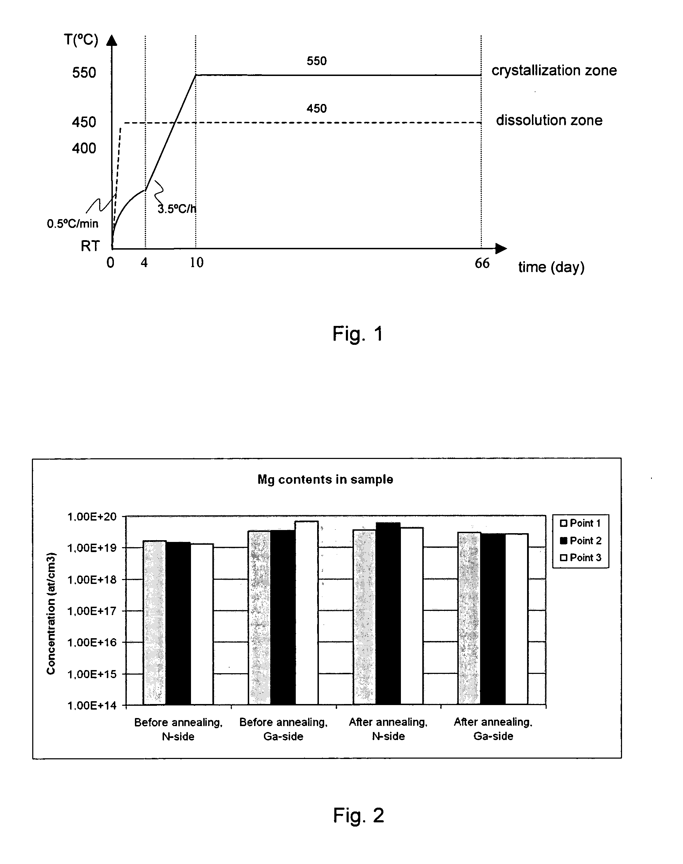

The dissolution zone was heated (at approx. 0.5°C/min) to 450°C. During that time the crystallization zone was not heated. After the assumed temperature of 450°C was reached in the dissolution zone (i.e. after approx. 15 hours since the beginning of the process - Fig. 1), the temperature in the crystallization zone reached approximately 170°C. Such distribution of temperature was maintained in the autoclave for 4 days (Fig. 1). During that time partial transition of gallium to the solution and complete reaction of the remaining gallium to polycrystalline GaN took place. Next, the temperature in the crystallization zone was raised (at approx. 3.5°C/h) to 550°C, and the temperature in the dissolution zone remained unchanged (at ca. 450°C). After about 10 days from the beginning of the process, a stable temperature distribution inside the autoclave was obtained (fig. 1). The pressure inside the autoclave was approx. 200MPa. As a result of such distribution of temperature, convection between the zones occurred in the autoclave, causing chemical transport of gallium nitride from the dissolution (upper) zone to the crystallization (lower) zone, where it was deposited on the seeds. The obtained distribution of temperature (i.e. 450°C in the dissolution zone and 550°C in the crystallization zone) was subsequently maintained for the next 56 days (until the end of the process - Fig. 1). At process conditions, the molar ratio of magnesium (acceptor dopant) to ammonia was ca. 0.0001.

As a result of the process, partial dissolution of the feedstock (i.e. polycrystalline GaN) occurred in the dissolution zone and growth of mono-crystalline gallium nitride occurred on nitrogen-terminated side of each of the seeds, in the form of mono-crystalline layers with the total thickness of approximately 3mm (measured along the *c* axis of the single crystal) on each seed.

The obtained gallium nitride single crystals were characterized by the FWHM of the X-ray rocking curve from the (0002) plane equal to approx. 18arcsec (for the Cu K α₁ line) and the curvature radius of the crystalline lattice of 54m. Microscopic examination of the C surface of those crystals (on the N-terminated side) showed that the surface dislocation density, as measured by the Etch Pit Density (EPD) method, was 3.0x10⁴/cm².

As far as the electric properties are concerned, the obtained material was p-type, with the carrier (hole) concentration of about 1.0x10¹⁸/cm³ and resistivity of about 9.5x10²Ω·cm.

Selected crystals from this process were subsequently annealed in a tubular furnace at the temperature of 1000°C, under nitrogen (N₂) flow, for 4h. After annealing, a semi-insulating (compensated) material was obtained, having the resistivity of about 5x10⁸Ω·cm, while its crystalline quality remained unchanged.

### Example 2 - obtaining of doped bulk gallium-containing nitride (Mg:NH₃=0.0005).

The same procedures were followed as in Example 1, with the only exception that to the feedstock (in the form of metallic gallium) - 0.28g of metallic magnesium as the acceptor dopant was added, which resulted in that at process conditions the molar ratio of magnesium (acceptor dopant) to ammonia was about 0.0005.

The obtained single crystals had the crystalline quality similar as in Example 1.

As far as the electric properties are concerned, the obtained material was p-type, with the carrier concentration of about 1.0x10¹⁹/cm³ and resistivity of about 1.5Ω·cm.

Selected crystals from this process were subsequently annealed in a tubular furnace at the temperature of 1100°C, under nitrogen (N₂) flow, for 2h. After annealing, a semi-insulating (compensated) material was obtained, with the resistivity of about 2.5x10¹¹Ω·cm, while its crystalline quality remained unchanged.

### Example 3 - obtaining of doped bulk gallium-containing nitride (Mg:NH₃=0.00025).

The same procedures were followed as in Example 1, with the only exception that to the feedstock (in the form of metallic gallium) - 0.14g of metallic magnesium as the acceptor dopant was added, which resulted in that at process conditions the molar ratio of magnesium (acceptor dopant) to ammonia was about 0.00025.

As far as the electric properties are concerned, the obtained material was p-type, with the carrier concentration of about 5.0x10¹⁸/cm³ and resistivity of about 8.0Ω·cm.

Selected crystals from this process were subsequently annealed in a tubular furnace at the temperature of 1000°C, under nitrogen (N₂) flow, for 4h. After annealing, a p-type material was obtained, with the carrier concentration of about 1.5x10¹⁸/cm³ and resistivity of about 5.0x10¹Ω·cm, while its crystalline quality remained unchanged.

### Example 4 - obtaining of doped bulk gallium-containing nitride (Mg:NH₃=0.001).

The same procedures were followed as in Example 1, with the only exception that to the feedstock (in the form of metallic gallium) - 0.56g of metallic magnesium as the acceptor dopant was added, which resulted in that at process conditions the molar ratio of magnesium (acceptor dopant) to ammonia was about 0.001.

The obtained single crystals had the crystalline quality similar as in Example 1. As far as the electric properties are concerned, the obtained material was p-type, with the carrier concentration of about 1.0x10¹⁹/cm³ and resistivity of about 1.7Ω·cm.

The crystals were subsequently annealed in a tubular furnace at the temperature of 1050°C, under nitrogen (N₂) flow, for 6h. After annealing, a semi-insulating (compensated) material was obtained, having the resistivity of about 1.4x10¹¹Ω·cm, while its crystalline quality remained unchanged.

### Example 5 - obtaining of doped bulk gallium-containing nitride (Zn:NH₃=0.001).

The same procedures were followed as in Example 1, with the only exception that to the feedstock (in the form of metallic gallium) - 1.5g of metallic zinc as the acceptor dopant was added, which resulted in that at process conditions the molar ratio of zinc (acceptor dopant) to ammonia was about 0.001.

The obtained gallium nitride single crystals were characterized by the FWHM of the X-ray rocking curve from the (0002) plane equal to approx. 19arcsec (for the Cu K α₁ line) and the curvature radius of the crystalline lattice of 100m. Microscopic examination of the C surface of those crystals (on the N-terminated side) showed that the surface dislocation density, as measured by the Etch Pit Density (EPD) method, was 9.0x10³/cm²_{.}

As far as the electric properties are concerned, the obtained material was p-type, with the carrier concentration of about 1x10¹⁸/cm³ and resistivity of about 1.6x10²Ω·cm.

Selected crystals from this process were subsequently annealed in a tubular furnace at the temperature of 1000°C, under nitrogen (N₂) flow, for 6h. After annealing, a semi-insulating (compensated) material was obtained, having the resistivity of more than 10¹²Ω·cm, while its crystalline quality remained unchanged.

### Example 6 - obtaining of doped bulk gallium-containing nitride (Zn:NH₃=0.0005).

The same procedures were followed as in Example 1, with the only exception that to the feedstock (in the form of metallic gallium) - 0.75g of metallic zinc as the acceptor dopant was added, which resulted in that at process conditions the molar ratio of zinc (acceptor dopant) to ammonia was about 0.0005.

The obtained single crystals had the crystalline quality similar as in Example 5. As far as the electric properties are concerned, the obtained material was p-type, having the resistivity of about 2.5x10²Ω·cm.

The crystals were subsequently annealed in a tubular furnace at the temperature of 1000°C, under nitrogen (N₂) flow, for 4h. After annealing, a p-type material was obtained, with the resistivity of about 2.3x10²Ω·cm, while its crystalline quality remained unchanged.

### Example 7 - obtaining of doped bulk gallium-containing nitride (Mn:NH₃=0.0003).

The same procedures were followed as in Example 1, with the only exception that to the feedstock (in the form of metallic gallium) - 0.38g of metallic manganese as the acceptor dopant was added, which resulted in that at process conditions the molar ratio of manganese (acceptor dopant) to ammonia was about 0.0003.

The obtained gallium nitride single crystals were characterized by the half width of the X-ray rocking curve (FWHM) from the (0002) plane equal to approx. 19arcsec (for the Cu K α₁ line) and the curvature radius of the crystalline lattice of 51 m. Microscopic examination of the C surface of those crystals (on the N-terminated side) showed that the surface dislocation density, as measured by the Etch Pit Density (EPD) method, was 5.0x10⁴/cm².

As far as the electric properties are concerned, the obtained material was semi-insulating (compensated), having the resistivity of about 3.2x10⁹Ω·cm.

Selected crystals from this process were subsequently annealed in a tubular furnace at the temperature of 1000°C, under nitrogen (N₂) flow, for 4h. After annealing, a semi-insulating (compensated) material was obtained, having the resistivity of about 5.2x10⁹Ω·cm, while its crystalline quality remained unchanged.

### Example 8 - obtaining of doped bulk gallium-containing nitride (Mn:NH₃=0.0005).

The same procedures were followed as in Example 1, with the only exception that to the feedstock (in the form of metallic gallium) - 0.63g of metallic manganese as the acceptor dopant was added, which resulted in that at process conditions the molar ratio of manganese (acceptor dopant) to ammonia was about 0.0005.

The obtained single crystals had the crystalline quality similar as in Example 7.

As far as the electric properties are concerned, the obtained material was semi-insulating (compensated), having the resistivity of about 5.3x10⁷Ω·cm.

Selected crystals from this process were subsequently annealed in a tubular furnace at the temperature of 1000°C, under nitrogen (N₂) flow, for 4h. After annealing, a semi-insulating (compensated) material was obtained, having the resistivity of about 6.2x10⁷Ω·cm, while its crystalline quality remained unchanged.

### Example 9 - obtaining of doped bulk gallium-containing nitride (Mn:NH₃=0.001).

The same procedures were followed as in Example 1, with the only exception that to the feedstock (in the form of metallic gallium) - 1.3g of metallic manganese as the acceptor dopant was added, which resulted in that at process conditions the molar ratio of manganese (acceptor dopant) to ammonia was about 0.001.

The obtained single crystals had the crystalline quality similar as in Example 7.

As far as the electric properties are concerned, the obtained material was semi-insulating (compensated), having the resistivity of about 8.2x10⁶Ω·cm. After annealing selected crystals from this process, in the same way as described in the previous Example, a semi-insulating (compensated) material was obtained, having the resistivity of about 8.4x10⁶Ω·cm, while its crystalline quality remained unchanged.

### Example 10 - obtaining of doped bulk gallium-containing nitride (Mn:NH₃=0.0005, Zn:NH₃=0.0005).

The same procedures were followed as in Example 1, with the only exception that to the feedstock (in the form of metallic gallium) - 0.63g of metallic manganese and 0.75g of metallic zinc as the acceptor dopants were added, which resulted in that at process conditions the molar ratio of manganese to ammonia as well as zinc to ammonia was about 0.0005, while the total molar ratio of acceptor dopants (manganese and zinc) to ammonia was about 0.001.

The obtained gallium nitride single crystals were characterized by the FWHM of the X-ray rocking curve from the (0002) plane equal to approx. 20arcsec (for the Cu K α₁ line) and the curvature radius of the crystalline lattice of 18m. Microscopic examination of the C surface of those crystals (on the N-terminated side) showed that the surface dislocation density, as measured by the Etch Pit Density (EPD) method, was 1.0x10⁴/cm²_{.}

As far as the electric properties are concerned, the obtained material was semi-insulating (compensated), having the resistivity of about 1.9x10⁷Ω·cm.

Selected crystals from this process were subsequently annealed in a tubular furnace at the temperature of 1000°C, under nitrogen (N₂) flow, for 5h. After annealing, a semi-insulating (compensated) material was obtained, having the resistivity of about 6.1x10⁷Ω·cm, while its crystalline quality remained unchanged.

### Example 11 - manufacturing polar substrates for epitaxy of single crystals obtained in Examples 1-10.

Selected crystals from the processes described above, annealed and not annealed, were cut using a wire saw into wafers having the diameter of about 25mm (1 inch) and thickness of 300µm each, oriented perpendicularly to the *c* crystalline axis (polar), and subsequently polished, so that they were ready to use in an epitaxial process

(so-called epi-ready polishing). On the thus prepared substrates various electronic devices (structures) were deposited in turns, such as HEMT transistors, photoresistors, integrated circuits, lasers and LED diodes, solar cells, UV detectors.

The thus obtained substrates were subject to various kinds of analysis. In particular, the composition of the substrates was investigated by the Secondary-Ion Mass Spectroscopy, SIMS, method, in order to determine the contents of acceptor dopant in the substrate and volume distribution of the dopant. Then epitaxial layers were deposited on the substrates and the quality of obtained layers was investigated, in particular by analyzing the photoluminescence spectrum.

The results of SIMS analysis, for the same substrate obtained in Example 2 (before and after annealing), are shown in Fig. 2. The measurements were taken both from gallium-terminated side and nitrogen-terminated side, before and after annealing, each time in three different points spaced away more than a dozen millimeter from one another. As evident from Fig. 2, the concentration of magnesium in the substrate is of the order of 10¹⁹/cm³ and is principally constant for all the measurements taken. It proves a highly uniform distribution of dopant contents within the volume of the substrate.

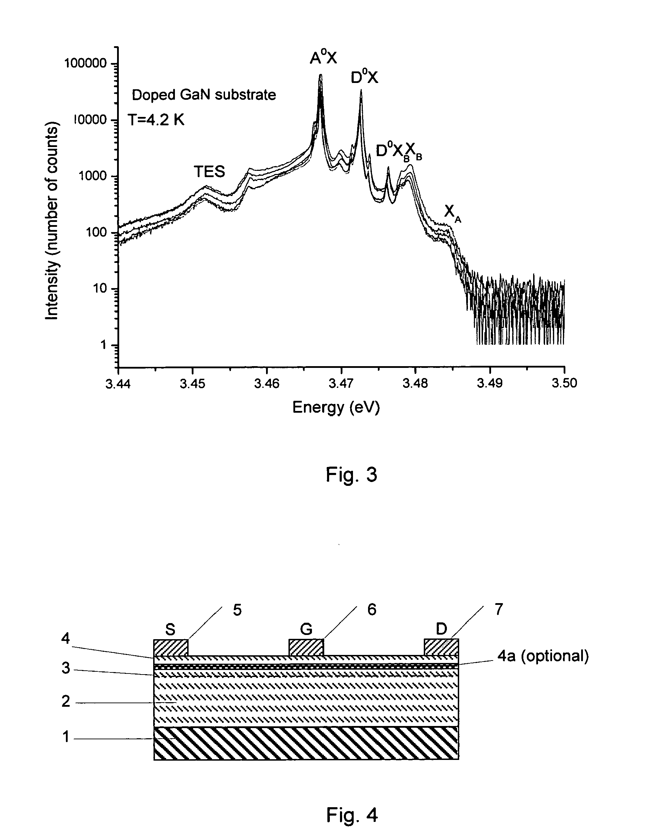

Fig. 3 presents a photoluminescence spectrum of an undoped GaN layer, having the thickness of about 1µm, deposited by the MOCVD method at the temperature of 1140°C on the same substrate (annealed). The spectrum was collected at the temperature of 4.2K, using a He-Cd laser, having the wavelength of 325nm. The spectrum is dominated by a strong emission in the band edge region of gallium nitride (A⁰X, D⁰X), and the half width of these lines is about 0.3meV. Different lines in the spectrum correspond to different measurement points, spaced away more than a dozen millimeter from one another (i.e. located in macroscopically different places). Attention is brought by a very high agreement between spectra obtained for different points, which proves that the investigated layer and the substrate are uniform. The presented photoluminescence spectrum is a "book" photoluminescence spectrum for GaN, with exceptionally low values of half width of the lines, indicating a very high quality of the substrate and the deposited layer.

### Example 12 - manufacturing non-polar substrates for epitaxy of single crystals obtained in Examples 1-10.

Other selected crystals from the processes described above, annealed and not annealed, were cut into wafers oriented perpendicularly to the *a* or *m* crystalline axis (non-polar). Out of these wafers, as the result of a typical processing, comprising orientation, mechanical polishing and chemico-mechanical polishing (CMP), substrates for epitaxy were manufactured, on which - subsequently - polarized-light emitters and detectors were obtained.

The thus obtained substrates were also subject to various kinds of analysis. In particular, the surface dislocation density, as measured by the Etch Pit Density (EPD) method on the epi-ready surface, was typically lower than 1.0x10²/cm².

### Example 13 - HEMT transistor on a semi-insulating substrate obtained in Example 2.

In the attached drawing, Fig. 4 presents a schematic cross-section of a HEMT transistor. According to Fig. 4, on an annealed, semi-insulating substrate of gallium nitride 1, obtained in the process described in Example 2, a 3µm thick buffer layer 2 of gallium nitride, as well as a 25nm thick layer 4 of Al_{0.3}Ga_{0.7}N were deposited by the MOCVD method. In this case, the buffer layer 2 of gallium nitride was undoped. The temperature of the epitaxial process was 1130°C. Subsequently, electrical contacts of Ni-Ti-Au were made: source 5, gate 6 and drain 7. On the interface of layers 2 and 4 a two-dimensional free electron gas (2DEG) 3 was obtained, wherein the carrier concentration in said gas was nₛ=1x10¹³/cm², and at the same time the mobility of the carriers was µ=1800cm²/(V·s).

### Example 14 - HEMT transistor on a semi-insulating substrate obtained in Example 2.

The same procedures were followed as in Example 13, with the only exception that the buffer layer 2 of gallium nitride was 2nm thick. In this case, layer 2 was doped with Si. In this case, the layer 2 secured flatness of the substrate 1. On the interface of layers 2 and 4 a two-dimensional free electron gas (2DEG) 3 was obtained, wherein the carrier concentration and the mobility of the carriers was similar as in Example 13.

### Example 15 - HEMT transistor on a semi-insulating substrate obtained in Example 2.

The same procedures were followed as in Example 13, with the only exception that the buffer layer 2 of undoped gallium nitride was 10nm thick. Presence of the layer 2 resulted in smoothing and flattening of the grown surface. On the interface of layers 2 and 4 a two-dimensional free electron gas (2DEG) 3 was obtained, wherein the carrier concentration and the mobility of the carriers was similar as in Example 13.

### Example 16 - HEMT transistor on a semi-insulating substrate obtained in Example 2.

The same procedures were followed as in Example 13, with the only exception that prior to deposition of the layer 4 of Al_{0.3}Ga_{0.7}N, a 1 nm thick layer 4a of AIN was deposited on the buffer layer 2 of gallium nitride. On the interface of layers 2 and 4a a two-dimensional free electron gas (2DEG) 3 was obtained, wherein the carrier concentration in said gas was nₛ=1x10¹³/cm², and at the same time the mobility of the carriers was µ=2200cm²/(V·s).

### Example 17 - HEMT transistor on a semi-insulating substrate obtained in Example 2.

The same procedures were followed as in Example 14, with the only exception that prior to deposition of the layer 4 of Al_{0.3}Ga_{0.7}N, a 1 nm thick layer 4a of AIN was deposited on the buffer layer 2 of gallium nitride. On the interface of layers 2 and 4a a two-dimensional free electron gas (2DEG) 3 was obtained, wherein the carrier concentration and the mobility of the carriers was similar as in Example 16.

### Example 18 - HEMT transistor on a semi-insulating substrate obtained in Example 2.

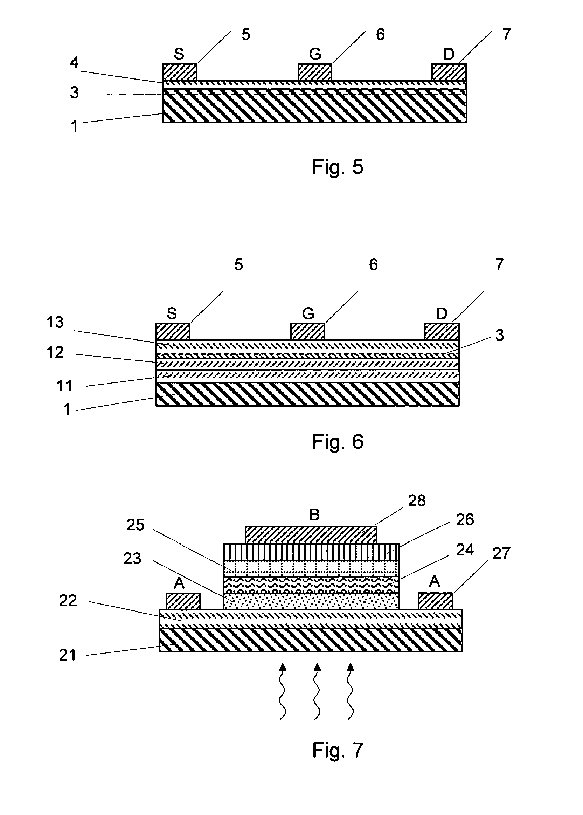

In the attached drawing, Fig. 5 presents a schematic cross-section of a HEMT transistor. According to Fig. 5, on an annealed, semi-insulating substrate of gallium nitride 1, obtained in the process described in Example 2, a 25nm thick layer 4 of Al_{0.3}Ga_{0.7}N was deposited by the MOCVD method. The temperature of the epitaxial process was 1130°C. Subsequently, electrical contacts of Ni-Ti-Au were made: source 5, gate 6 and drain 7. On the interface of the layer 4 and the substrate 1 a two-dimensional free electron gas (2DEG) 3 was obtained, wherein the carrier concentration in said gas was nₛ=8x10¹²/cm², and at the same time the mobility of the carriers was µ=1700cm²/(V·s).

### Example 19 - HEMT transistor on a semi-insulating substrate obtained in Example 2.

In the attached drawing, Fig. 6 presents a schematic cross-section of a HEMT transistor. According to Fig. 6, on the N-side an annealed, semi-insulating substrate of gallium nitride 1, obtained in the process described in Example 2, a 22nm thick layer 11 of Al_{0.26}Ga₀.₇₄N doped with Si, a 12nm thick layer 12 of undoped Al_{0.26}Ga_{0.74}N, and a 26nm thick layer 13 of undoped GaN were deposited by the MOCVD method. The temperature of the epitaxial process was 1130°C. Subsequently, electrical contacts of Ni-Ti-Au were made: source 5, gate 6 and drain 7. On the interface of layers 12 and 13 a two-dimensional free electron gas (2DEG) 3 was obtained, wherein the carrier concentration in said gas was nₛ=1x10¹³/cm², and at the same time the mobility of the carriers was µ=1800cm²/(V·s).

### Example 20 - HEMT transistor on a semi-insulating substrate obtained in Example 2.

The same procedures were followed as in Example 16, with the only exception that the first 500nm of the buffer layer 2 of gallium nitride were doped with Fe, while the next 2.1µm of this layer was undoped, which resulted in a 2.6µm thick buffer layer 2. On the interface of layers 2 and 4a a two-dimensional free electron gas (2DEG) 3 was obtained, wherein the carrier concentration in said gas was nₛ=1x10¹³/cm², and at the same time the mobility of the carriers was µ=2200cm²/(V·s).

Similar devices as those disclosed in Examples 13-20 were obtained on other annealed semi-insulating substrates of gallium nitride, obtained in the processes described in Examples 1, 4, 5, 7, 8, 9, 10.

### Example 21 - UV detector on a semi-insulating substrate obtained in Example 2.

In the attached drawing, Fig. 7 presents a schematic cross-section of a UV detector of n-p-n type. According to Fig. 7, on an annealed, semi-insulating substrate of gallium nitride 21, obtained in the process described in Example 2, the following layers were deposited by the MOCVD method:
- a Si-doped *n*⁺ layer 22 of Al_{0.47}Ga_{0.53}N,
- a Mg-doped *p* layer 23 of Al_{0.2}Ga_{0.8}N,
- a Mg-doped *p*⁺ layer 24 of Al_{0.2}Gao_{0.8}N,
- a Mg-doped *p* layer 25 of GaN and
- a Si-doped *n*⁺ layer 26 of GaN.

Moreover, typical electrical contacts 27, 28 of Ni-Au were made, as shown in Fig. 7. The temperature of the epitaxial process was 1130°C. In this way, a structure of a n-p-n type UV detector was obtained.

Similar devices as those disclosed in Example 21 were obtained on other annealed semi-insulating substrates of gallium nitride, obtained in the processes described in Examples 1, 4, 5, 7, 8, 9, 10.

## Claims

1. A method of obtaining bulk mono-crystalline gallium-containing nitride by seeded crystallization from supercritical ammonia-containing solution, containing ions of Group I metals and ions of acceptor dopant, **characterized in that** at process conditions the molar ratio of acceptor dopant ions to supercritical ammonia-containing solvent is at least 0.0001, preferably at least 0.0005, more preferably at least 0.0010.

2. The method according to claim 1, wherein said acceptor dopant is at least one element selected from the group consisting of Mg, Zn, Mn.

3. The method according to claim 1 or 2, wherein after the crystallization step said nitride is annealed in the atmosphere of a nitrogen-containing gas, preferably comprising molecular nitrogen N₂, ammonia NH₃ or a mixture thereof.

4. The method according to claim 3, wherein the temperature of annealing is between 800°C and 1200°C, preferably between 950°C and 1150°C, and wherein the duration of annealing is between 0.5h and 16h, preferably between 2h and 6h.

5. A bulk mono-crystalline gallium-containing nitride, obtainable by the method according to any one of the preceding claims 1 to 4.

6. The nitride according to claim 5, constituting a p-type material, which resistivity is preferably not exceeding 10³Ω·cm, more preferably not exceeding 10²Ω·cm, most preferably not exceeding 10¹Ω·cm.

7. The nitride according to claim 5, constituting a semi-insulating material, which resistivity is preferably at least 10⁵Ω·cm, more preferably at least 10⁷Ω·cm and most preferably at least 10¹⁰Ω·cm.

8. A substrate of bulk mono-crystalline gallium-containing nitride according to claim 5, 6 or 7.

9. The substrate according to claim 8, wherein its epitaxial surface is essentially polar.

10. The substrate according to claim 8, wherein its epitaxial surface is essentially non-polar or semi-polar.

11. A device obtained on the substrate according to claim 9 or 10, when dependent on claim 8, when dependent on claim 6, preferably a laser diode, LD, a light-emitting diode, LED, a UV detector, a solar cell, a polarized-light emitter, or a polarized-light detector.

12. A device obtained on the substrate according to claim 9 or 10, when dependent on claim 8, when dependent on claim 7, preferably a high electron mobility transistor, HEMT, an integrated circuit, IC, a UV detector, a solar cell, or a photoresistor.

13. A device according to claim 12, wherein the device is a high electron mobility transistor, HEMT, said high electron mobility transistor comprises the substrate (1), a buffer layer of GaN (2), an optional layer (4a) of AIN and a layer (4) of AlₓGa₁₋ₓN, 0<x≤1, wherein the buffer layer of GaN (2) is deposited directly on the substrate (1), the optional layer (4a) of AIN is deposited on the buffer layer of GaN (2) and the layer (4) of AlₓGa₁₋ₓN, 0<x≤1 is deposited on the buffer layer of GaN (2) or on the layer (4a) of AIN, if this layer is present.

14. A device according to claim 12, wherein the device is a high electron mobility transistor, HEMT, said high electron mobility transistor comprises the substrate (1) and layer (4) of AlₓGa₁₋ₓN, 0<x≤1, wherein the layer (4) of AlₓGa₁₋ₓN, 0<x≤1, is deposited directly on the substrate (1).

15. A device according to claim 12, wherein the device is a high electron mobility transistor, HEMT, said high electron mobility transistor comprises the substrate (1), an epitaxial layer (11) of AlₓGa₁₋ₓN, 0<x≤1, doped with Si, deposited on the N-side of the substrate (1), a layer (12) of undoped AlₓGa₁₋ₓN, 0<x≤1, deposited on the layer (11) of AlₓGa₁₋ₓN, 0<x≤1, doped with Si, and layer (13) of undoped GaN, deposited on the layer (12) of undoped AlₓGa₁₋ₓN, 0<x≤1.
